**Europäisches Patentamt**

**European Patent Office**

**Office européen des brevets**

(19)

(11) Veröffentlichungsnummer: **0 167 948**
**B1**

(12)
# EUROPÄISCHE PATENTSCHRIFT

(45) Veröffentlichungstag der Patentschrift:
18.01.89

(51) Int. Cl.⁴: **G 03 F 1/00**

(21) Anmeldenummer: **85108088.7**

(22) Anmeldetag: **29.06.85**

(54) Maske für die Röntgenlithographie.

(30) Priorität: **07.07.84 DE 3425063**

(43) Veröffentlichungstag der Anmeldung:
**15.01.86 Patentblatt 86/3**

(45) Bekanntmachung des Hinweises auf die Patenterteilung:
**18.01.89 Patentblatt 89/3**

(84) Benannte Vertragsstaaten:
**DE FR GB**

(56) Entgegenhaltungen:
**US-A- 3 742 230**

**J. VAC. SCI. TECHNOL., Band 16, Nr. 6, November/Dezember 1979, Seiten 1959-1961, American Vacuum Society; D. MAYDAN et al.: "Boron nitride mask structure for X-ray lithography"**
**JAPANESE JOURNAL OF APPLIED PHYSICS, Band 21, Nr. 5, Teil 1, Mai 1982, Seiten 762-767, Tokyo, JP; T. EBATA et al.: "Transparent X-ray lithography masks"**

(73) Patentinhaber: **Licentia Patent-Verwaltungs-GmbH, Theodor-Stern-Kai 1, D-6000 Frankfurt/Main 70 (DE)**
Patentinhaber: **TELEFUNKEN electronic GmbH, Theresienstrasse 2, D-7100 Heilbronn (DE)**

(72) Erfinder: **Hersener, Jürgen, Dr. Dipl.-Phys., Fünf-Bäume-Weg 34, D-7900 Ulm (DE)**
Erfinder: **Herzog, Hans-Joest, Dipl.-Phys., Staufenbergstrasse 18, D-7910 Neu-Ulm/Pfuhl (DE)**
Erfinder: **Strohm, Karl, Dr. Dipl.-Phys., Bei der Pilzbuche 40, D-7900 Ulm (DE)**

(74) Vertreter: **Maute, Hans-Jürgen, Dipl.-Ing., TELEFUNKEN electronic GmbH Theresienstrasse 2, D-7100 Heilbronn (DE)**

**Beschreibung**

Die Erfindung betrifft eine Maske für die Röntgenlithographie nach dem Oberbegriff des Patentanspruches 1.

Eine derartige Maske ist aus der US-A 3 742 230 bekannt. Insbesondere für die Herstellung von Halbleiterbauelementen in einer sogenannten VLSI-Technik («very large scale integration») werden Belichtungsmasken benötigt, welche eine Herstellung von Halbleiterstrukturen ermöglichen, die im Bereich eines Mikrometers und darunter liegen. Derartig kleine geometrische Strukturen werden z.B. mittels Röntgenlicht von der Maske auf eine mit für das Röntgenlicht empfindlichem Lack beschichtete Halbleiterscheibe, das Substrat übertragen und dann mit den in der Halbleitertechnologie geläufigen Verfahren entwickelt und weiterverarbeitet, z.B. mit Hilfe von Diffusions- sowie Ätzverfahren. Die Herstellung derartiger VLSI-Halbleiterbauelemente erfordert, dass mehrere Belichtungs-, Diffusions- und Ätzvorgänge zeitlich nacheinander durchgeführt werden mit unterschiedlich strukturierten Masken. Diese Masken müssen justiert werden bezüglich der auf dem Substrat bereits vorhandenen Strukturen, z.B. mit Hilfe von geeigneten Justiermasken. Derartige Justiervorgänge erfordern eine Genauigkeit (Toleranz) von weniger als 0,1 μm. Die derzeitige wirtschaftliche Lage erfordert ausserdem ein kostengünstiges sowie zeitlich möglichst kurzes Herstellungsverfahren derartiger VLSI-Halbleiterbauelemente.

Die bekannte Röntgenlithographiemaske gemäss der oben genannten Literaturstelle besteht aus einer die strukturierte Absorberschicht tragende Siliziumdioxydschicht, die auf einer die Membran bildenden Siliziumschicht angeordnet ist, wobei zur mechanischen Stabilisierung diese Membran im Randbereich mit einem Siliziumträger verbunden ist. Um eine dünne und steife Membran zu erzielen wird entweder die Membran mit Bor dotiert, wobei der Siliziumträger undotiert ist, oder der Siliziumträger wird mit Arsen dotiert, wobei nun die Siliziummembran undotiert bleibt. Diese Dotierung mit Bor bzw. Arsen bewirkt jeweils einen Spannungszustand in der Siliziummembran.

Da jedoch Bor einen kleineren Kovalenzradius besitzt als Silizium, entstehen in der Bor-Schicht mechanische Spannungen, die ein unkontrolliertes Zusammenziehen einer derartigen Membran zur Folge haben, wodurch störende sowie nicht vorhersehbare mechanische Verzüge der Strukturen in der Absorberschicht entstehen können.

Der Erfindung liegt daher die Aufgabe zugrunde, eine gattungsgemässe Maske anzugeben, die in einem kurzen Zeitraum zuverlässig sowie kostengünstig herstellbar ist, deren mechanische Verzüge, insbesondere diejenigen der Absorberstruktur, vernachlässigbar klein sind und die ein kostengünstiges Justierverfahren ermöglicht.

Diese Aufgabe wird gelöst durch die im kennzeichnenden Teil des Patentanspruches 1 angegebenen Merkmale. Zweckmässige Ausgestaltungen und Weiterbildungen sind den Unteransprüchen entnehmbar.

Ein Vorteil der Erfindung besteht darin, dass die Membran an (Röntgen-)Absorberschicht freien Stellen durchlässig ist für sichtbares Licht mit einem Wellenlängenbereich von ungefähr 400 nm bis 800 nm. Dadurch werden kostengünstig durchführbare lichtoptische (Masken-)Justierverfahren ermöglicht. In der Maske zusätzlich angebrachte lichtdurchlässige (Justier-)Fenster werden nicht benötigt. Durch solche Fenster werden in der Maske störende mechanische Spannungen erzeugt, die zu unerwünschten mechanischen Verzügen der Maske führen oder sogar deren Bruchwahrscheinlichkeit erhöhen. Weiterhin werden die durch die Bor-Dotierung hervorgerufenen Nachteile weitgehend durch die Germanium-Dotierung kompensiert.

Die Erfindung wird im folgenden anhand eines Ausführungsbeispiels näher erläutert unter Bezugnahme auf eine schematische Zeichnung:

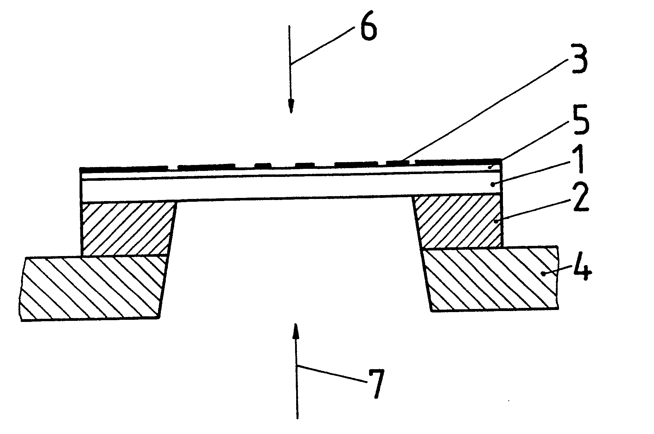

Die Figur zeigt einen Querschnitt durch eine kreisscheibenförmige Maske mit einem Aussendurchmesser von ungefähr 75 mm. Der Träger, auf welchem die (Röntgenlicht-)Absorberschicht 3 aufgebracht ist, besteht aus einer Silizium(Si)-haltigen, ungefähr 2 μm dicken Membran 1, die durch einen Si-haltigen, ungefähr 0,4 mm dicken und 12,5 mm breiten Ring 2 mechanisch derart gespannt wird, dass mechanische Verzüge der Membran 1 und des Ringes 2 vermieden werden. Dadurch wird erreicht, dass mechanische Verzüge der geometrischen Strukturen der Absorberschicht 3 in einem Bereich um 0,1 μm liegen oder sogar kleiner sind.

Auf der Membran 1 wird zunächst ganzflächig eine Diffusionssperrschicht 5 angebracht, z.B. eine Siliziumnitrid- und/oder eine Siliziumdioxydschicht mit einer Dicke von ungefähr 80 nm. Eine derartige Diffusionssperrschicht 5 verhindert einerseits eine Diffusion des Materials der nachfolgend aufgebrachten Absorberschicht 3 in die Membran 1 und umgekehrt und wirkt andererseits als Antireflexschicht ($\lambda$/4-Schicht) für sichtbares Licht.

Eine beispielhafte Herstellung einer solchen Maske geht aus von einer kreisförmigen einkristallinen Silizium(Si)-Scheibe mit einer sogenannten (100)-Kristallorientierung, einem Durchmesser von ungefähr 75 mm und einer Dicke von ungefähr 0,4 mm. Eine solche Si-Scheibe wird auch «wafer» genannt und ist ein derzeit kostengünstig herstellbares Ausgangsprodukt für Halbleiterbauelemente. Auf die durch den Pfeil 6 gekennzeichnete Seite der Si-Scheibe wird in einem epitaxialen Verfahren eine gleichzeitig mit Bor und Germanium dotierte Si-Schicht abgeschieden. Die entstehende Epitaxieschicht hat eine Dicke von ungefähr 2 μm, entsprechend der Dicke der herzustellenden Membran 1. Durch die Bor-Dotierung entsteht eine elektrisch p-leitende Si-Halbleiterschicht mit einer p-Dotierung, deren Konzentration grösser ist als $7 \times 10^{19} \mathrm{cm}^{-3}$. Eine derartig mit Bor dotierte Schicht wirkt vorteilhafterweise als Ätzstopschicht, was nachfolgend erläutert wird.

Diese hohe Bor-Dotierung hat jedoch den Nachteil, dass Bor einen kleineren Kovalenzradius besitzt als Silizium. Dadurch entstehen in der Bordotierten Schicht mechanische Spannungen, die ein unkontrollierbares Zusammenziehen einer derartigen Membran bewirken würden, es entstünden störende sowie nicht vorhersehbare mechanische Verzüge der Strukturen in der Absorberschicht 3. Weiterhin bewirkt diese hohe Bor-Dotierung in nachteiliger Weise Gitterfehler an der Grenzschicht zum darunter liegenden nicht dotierten Silizium. Diese Gitterfehler verringern einerseits in störender Weise die mechanische Stabilität der Membran 1 und bewirken andererseits eine störende Streubrechung des sichtbaren Lichts, wodurch der bereits erwähnte kostengünstige optische Justiervorgang erschwert wird oder sogar unmöglich wird. Diese Nachteile werden vermieden durch die bereits erwähnte Germanium(Ge)-Dotierung, da Germanium einen grösseren Kovalenzradius besitzt als Silizium. Durch die Ge-Dotierung sind daher insbesondere die mechanischen Spannungen vollständig kompensierbar, die durch die Bor-Dotierung entstanden sind. Es ist jedoch vorteilhaft, diese Spannungen nicht vollständig zu kompensieren, damit eine Deformation der fertigen Maske vermieden wird, z.B. ein Durchhängen durch das Eigengewicht von Membran und Absorberschicht. Es ist zweckmässig, eine Bor-Dotierung von ungefähr $1,5 \times 10^{20} \mathrm{cm}^{-3}$ sowie eine Germanium-Dotierung von ungefähr $13 \times 10^{20} \mathrm{cm}^{-3}$ zu wählen. Auf die derart dotierte Schicht wird dann die Diffusionssperrschicht 5 aufgebracht, z.B. durch ein in der Halbleitertechnologie geläufiges Verfahren, z.B. ein CVD-Verfahren.

Anschliessend wird die Absorberschicht 3 aufgebracht, z.B. durch Aufdampfen und nachfolgendem galvanischen Verstärken. Das erforderliche Strukturieren ist z.B. durch an das Absorbermaterial angepasste Ätzverfahren möglich. Als Material für die Absorberschicht 3 sind Schwermetalle geeignet, z.B. Titan (Ti) und Gold, Chrom (Cr) und Gold (Au) und/oder eine Legierung vom Invar-Typ. Letztere ermöglicht in vorteilhafter Weise eine zusätzliche Temperaturkompensation der Maske, gemäss der DE-OS 32 15 316.

Die derart vorgefertigte Si-Scheibe wird nun auf der der Absorberschicht 3 abgewandten Seite maskiert entsprechend dem herzustellenden Ring 2, z.B. mittels eines aufgebrachten Oxids mit einem eingeätzten Fenster. Das nunmehr freiliegende Silizium im Bereich des Fensters wird gleichmässig weggeätzt in Richtung des zweiten Pfeiles 7, z.B. mit Hilfe einer Lösung aus Äthylendiamin, Pyrokatechol und Wasser, einer sogenannten EDP-Ätzlösung. Dieser Ätzvorgang wirkt selektiv lediglich auf das undotierte Silizium und wird selbsttätig an der erwähnten B-Ge-dotierten Schicht beendet. Es entsteht die gewünschte Maske.

Die Maske kann mechanisch weiter verstärkt werden durch einen entsprechend geformten mechanischen Trägerkörper 4, welcher auf dem Ring 2 befestigt wird, z.B. durch Kleben. Alternativ dazu ist es möglich, den Trägerkörper 4 bereits vor dem Ätzen mit EDP-Lösung auf der Siliziumscheibe zu befestigen und anschliessend den erwähnten Ätzvorgang vorzunehmen.

Die Erfindung ist nicht auf das beschriebene Ausführungsbeispiel beschränkt, sondern sinngemäss auf weitere anwendbar. Beispielsweise ist es möglich, die erwähnte B- und Ge-dotierte Si-Schicht durch Diffusions- und/oder Implantations- und/oder Molekularstrahlepitaxieverfahren herzustellen.

## Patentansprüche

1. Maske für die Röntgenlithographie, insbesondere zur Mustererzeugung auf einem mit strahlungsempfindlichen Lack beschichteten Halbleitersubstrat, bestehend aus einem im wesentlichen strahlungsdurchlässigem Träger, auf dem eine geometrisch strukturierte Absorberschicht angebracht ist, wobei der Träger aus einer Siliziumhaltigen, im wesentlichen einkristallinen Membran (1) besteht, die mechanisch gespannt wird durch einen an ihrem Randbereich vorhandenem Silizium-haltigen, im wesentlichen einkristallinen Ring (2), welcher sich an der der Absorberschicht (3) abgewandten Seite der Membran (1) befindet, dadurch gekennzeichnet, dass die Membran (1) zur Erzeugung eines vorherbestimmbaren mechanischen Spannungszustandes sowohl mit Bor als auch mit Germanium dotiert ist, und dass die Dicke sowie die Dotierungskonzentration der Membran (1) derart gewählt sind, dass diese eine für Justiervorgänge ausreichende Durchlässigkeit im sichtbaren Spektralbereich besitzt.

2. Maske nach Anspruch 1, dadurch gekennzeichnet, dass die Silizium-haltige Membran (1) ca. 2 μm dick ist und die Bor- bzw. Germanium-Dotierungskonzentration einen Wert von ca. $1,5 \times 10^{20} \mathrm{cm}^{-3}$ bzw. $13 \times 10^{20} \mathrm{cm}^{-3}$ aufweist.

3. Maske nach Anspruch 1 oder Anspruch 2, dadurch gekennzeichnet, dass an dem Ring (2) zusätzlich ein mechanischer Trägerkörper (4) zur weiteren mechanischen Stabilisierung der Membran (1) und des Ringes (2) befestigt ist.

4. Maske nach einem der vorhergehenden Ansprüche, dadurch gekennzeichnet, dass der mechanische Trägerkörper (4) aus Glas und/oder einer Eisen-Nickel-Legierung vom Invar-Typ besteht, welche einen dem Si angepassten thermischen Ausdehnungskoeffizienten besitzen, zumindest im Arbeitstemperaturbereich der Maske.

5. Maske nach einem der vorhergehenden Ansprüche, dadurch gekennzeichnet, dass die Membran (1) im wesentlichen ganzflächig bedeckt ist mit einer Diffusionssperrschicht (5) für die nachfolgend darauf angebrachte Absorberschicht (3).

6. Maske nach einem der vorhergehenden Ansprüche, dadurch gekennzeichnet, dass die Diffusionssperrschicht (5) Siliziumnitrid und/oder Siliziumdioxid enthält.

7. Maske nach einem der vorhergehenden Ansprüche, dadurch gekennzeichnet, dass die Diffusionssperrschicht (5) als Antireflexschicht ausgebildet ist für das beim Justiervorgang benutzte sichtbare Licht.

8. Maske nach einem der vorhergehenden Ansprüche, dadurch gekennzeichnet, dass in der Absorberschicht (3) mindestens ein Schwermetall vorhanden ist und/oder eine Legierung vom Invar-Typ.

9. Maske nach einem der vorhergehenden Ansprüche, dadurch gekennzeichnet, dass die Materialien der Absorberschicht (3) sowie die Membran (1) derart gewählt sind, dass durch Temperaturänderungen unterschiedliche Verzüge zwischen der Absorberschicht (3) und der Membran (1) vermieden werden zumindest im Arbeitstemperaturbereich der Maske.

### Claims

1. Mask for X-ray lithography, in particular for generating a pattern on a semiconductor substrate coated with radiation-sensitive lacquer; consisting of a substantially translucent carrier upon which a geometrically structured absorber layer is applied, wherein the carrier consists of a silicon-containing, substantially monocrystalline membrane (1), which is held under mechanical tension by a silicon-containing, substantially monocrystalline ring (2) in the area of its rim, which ring is located on the side of the membrane (1) directed away from the absorber layer (3), characterised in that the membrane (1) is doped with boron and with germanium so as to produce a predetermined mechanical state of tension, and that both the thickness and the concentration of doping of the membrane (1) are selected so as to provide the membrane with a transmissibility in the visible spectral range that is adequate for alignment procedures.

2. Mask according to claim 1, characterised in that the silicon-containing membrane (1) is approx. 2 µm thick and the doping concentrations of the boron and germanium are approximately $1.5 \times 10^{20} cm^{-3}$ and $13 \times 10^{20} cm^{-3}$ respectively.

3. Mask according to claim 1 or claim 2, characterised in that a mechanical carrier body (4) is attached to the ring (2) for further mechanical stabilisation of the membrane (1) and the ring (2).

4. Mask according to any one of the foregoing claims, characterised in that the mechanical carrier body (4) consists of glass and/or of an iron nickel alloy of the Invar type, having a thermal coefficient of expansion adapted to correspond to that of the Si, at least in the working temperature range of the mask.

5. Mask according to any one of the foregoing claims, characterised in that the membrane (1) is covered over its complete surface with a diffusion barrier layer (5) for the absorber layer (3) subsequently applied.

6. Mask according to any one of the foregoing claims, characterised in that the diffusion barrier layer (5) contains silicon nitride and/or silicon dioxide.

7. Mask according to any one of the foregoing claims, characterised in that the diffusion barrier layer (5) is in the form of an antireflection layer for light in the visible range used in mask alignment procedures.

8. Mask according to any one of the foregoing claims, characterised in that the absorber layer (3) contains at least one heavy metal and/or one alloy of the Invar type.

9. Mask according to any one of the foregoing claims, characterised in that the absorber layer (3) and the membrane (1) are of materials selected so that distortion differences between the absorber layer (3) and the membrane (1) due to temperature changes are avoided, at least in the working temperature range of the mask.

### Revendications

1. Masque pour la lithographie à rayons X ou radiolithographie, en particulier pour produire des motifs sur un substrat semi-conducteur revêtu d'une laque sensible au rayonnement, formé d'un support qui est essentiellement perméable au rayonnement et sur lequel est appliqué une couche d'absorption structurée géométriquement, le support étant constitué d'une membrane (1) contenant du silicium, qui est essentiellement monocristalline et est tendue mécaniquement par un anneau (2) prévu dans la zone du bord de la membrane, du côté de la membrane se trouvant à l'opposé de la couche d'absorption (3), l'anneau (2) contenant du silicium et étant essentiellement monocristallin, caractérisé en ce que, en vue de la création d'un état de tension mécanique pouvant être fixé d'avance, la membrane (1) est dopée à la fois au bore et au germanium, et que l'épaisseur de la membrane (1), de même que les concentrations des dopants, sont choisies de manière que la membrane (1) possède une transparence suffisante pour des opérations d'ajustement dans le domaine spectral visible.

2. Masque selon la revendication 1, caractérisé en ce que la membrane (1), contenant du silicium, possède une épaisseur d'environ 2 µm et les concentrations des dopants constitués par le bore et le germanium sont respectivement d'environ $1,5 \times 10^{20} cm^{-3}$ et $13 \times 10^{20} cm^{-3}$.

3. Masque selon la revendication 1 ou 2, caractérisé en ce qu'un support mécanique (4) est fixé en plus à l'anneau (2) en vue d'une stabilisation mécanique supplémentaire de la membrane (1) et de l'anneau (2).

4. Masque selon une des revendications précédentes, caractérisé en ce que le support mécanique (4) est en verre et/ou en alliage fer/nickel du type «Invar», qui possèdent, tout au moins dans la plage des températures de travail du masque, un coefficient de dilatation thermique qui est adapté au silicium.

5. Masque selon une des revendications précédentes, caractérisé en ce que la membrane (1) est recouverte, essentiellement sur toute sa surface, par une couche d'arrêt de diffusion (5) pour la couche d'absorption (3) déposée ensuite sur elle.

6. Masque selon une des revendications précédentes, caractérisé en ce que la couche d'arrêt de diffusion (5) contient du nitrure de silicium et/ou du dioxyde de silicium.

7. Masque selon une des revendications précédentes, caractérisé en ce que la couche d'arrêt de diffusion (5) est réalisée comme une couche anti-reflets pour la lumière visible utilisée lors de l'opération d'ajustement.

8. Masque selon une des revendications précédentes, caractérisé en ce que la couche d'absorption (3) contient au moins un métal lourd et/ou un alliage de type «Invar».

9. Masque selon une des revendications précédentes, caractérisé en ce que les matériaux de la couche d'absorption (3) et de la membrane (1) sont choisis de manière que des variations de température ne puissent pas provoquer des déformations différentes entre la couche d'absorption (3) et la membrane (1), tout au moins dans la plage des températures de travail du masque.